# EUROPEAN PATENT APPLICATION

(11) **EP 4 439 983 A1**
(43) Date of publication of application: **02.10.2024**
(21) Application number: 23210521.3
(22) Date of filing: 17.11.2023
(51) Int. Cl.: H03K 19/003, G06F 30/36

(54) **METHOD AND SYSTEM FOR HARDENING A TRANSISTOR LOGIC GATE**

(30) Priority: 31.03.2023 US 202318193861
(71) Applicant: INTEL Corporation, Santa Clara, CA 95054 (US)
(72) Inventor: GILL, Balkaran, Cornelius, 97113 (US); CHO, Minki, Portland, 97229 (US)
(74) Representative: HGF

(57) **Abstract**

The disclosure is directed to methods, a standard cell, and a system for forming a logic gate with reduced aging including organizing a plurality of transistors to provide a logic function for the logic gate, identifying a least one transistor in the plurality of transistors having a voltage swing to an output above a predetermined threshold, and coupling a voltage dividing transistor to the at least one transistor to reduce a voltage across the at least one transistor such that the voltage dividing transistor lowers a voltage across the at least one transistor.

## Description

### FIELD OF THE DISCLOSURE

This disclosure generally relates to field of transistors, and more particularly, relates to methods and system for a preventing aging in logic gate transistors.

### BACKGROUND

A standard cell (SC) may correspond to a basic cell such as AND, OR, NOR, an inverter, or the like. Premature aging or inconsistent aging among the transistors may occur within the cell. What is needed is a system and method of organizing a standard cell to extend and harden the life cycle of the standard cell.

### BRIEF DESCRIPTION OF THE DRAWINGS

A detailed description is set forth below with reference to the accompanying drawings. The use of the same reference numerals may indicate similar or identical items. Various embodiments may utilize elements and/or components other than those illustrated in the drawings, and some elements and/or components may not be present in various embodiments. Elements and/or components in the figures are not necessarily drawn to scale. Throughout this disclosure, depending on the context, singular and plural terminology may be used interchangeably.
FIG. 1 illustrates an AND OR inverter (AOI) logic gate in accordance with an embodiment of the disclosure.
FIG. 2 illustrates a transistor implementation of the AOI logic gate in accordance with an embodiment of the disclosure.
FIG. 3 illustrates a transistor implementation of the AOI logic gate with an added transistor voltage divider in accordance with an embodiment of the disclosure.
FIG. 4 illustrates an OAI logic gate in accordance with an embodiment of the disclosure.
FIG. 5 illustrates a transistor implementation of the OAI logic gate in accordance with an embodiment of the disclosure.
FIG. 6 illustrates a transistor implementation of the OAI logic gate in accordance with an embodiment of the disclosure.
FIG. 7 illustrates a flow diagram in accordance with an embodiment of the disclosure.
FIG. 8 illustrates a memory and a processing circuit in accordance with an embodiment of the disclosure.

### DETAILED DESCRIPTION

The following detailed description refers to the accompanying drawings. The same reference numbers may be used in different drawings to identify the same or similar elements. In the following description, for purposes of explanation and not limitation, specific details are set forth such as particular structures, architectures, interfaces, techniques, etc. in order to provide a thorough understanding of the various aspects of various embodiments. However, it will be apparent to those skilled in the art having the benefit of the present disclosure that the various aspects of the various embodiments may be practiced in other examples that depart from these specific details. In certain instances, descriptions of well-known devices, circuits, and methods are omitted so as not to obscure the description of the various embodiments with unnecessary detail. For the purposes of the present document, the phrases "A or B" and "A/B" mean (A), (B), or (A and B).

In terms of a general overview, this disclosure is generally directed to systems and methods for forming a logic gate with reduced aging.

In one or more embodiments, a method is directed to organizing a plurality of transistors to provide a logic function for a logic gate, identifying a least one transistor in the plurality of transistors having a voltage swing to an output above a predetermined threshold, and coupling a voltage dividing transistor to the at least one transistor to reduce a voltage across the at least one transistor such that the voltage dividing transistor lowers a voltage across the at least one transistor.

In one or more embodiments the method further includes identifying a transistor in the logic gate having an output to either a ground or a voltage source as the at least one transistor.

In one or more embodiments the method further includes measuring a voltage output swing at each of the plurality of transistors in the logic function to identify the at least one transistor having a voltage swing above the predetermined threshold, and identifying a transistor with a highest voltage output swing as the at least one transistor.

In one or more embodiments, the identifying the least one transistor in the plurality of transistors having the voltage swing to an output above the predetermined threshold includes determining a guard-band associated with each of the plurality of transistors to add to a nominal voltage that avoids timing constraints on the logic gate and coupling the voltage dividing transistor when the voltage dividing transistor is within the guard-band.

Another embodiment is directed to a system for forming a logic gate with reduced aging including a memory and processing circuitry coupled to the memory configured to determine an alteration in a standard cell to reduce aging, the processing circuitry operable to organize a plurality of transistors to provide a logic function for the logic gate, identify a least one transistor in the plurality of transistors having a voltage swing to an output above a predetermined threshold, and couple a voltage dividing transistor to the at least one transistor, the voltage dividing transistor operable to reduce a voltage across the at least one transistor such that the voltage dividing transistor lowers a voltage across the at least one transistor thereby reducing aging of the logic gate.

In one or more embodiments the processing circuitry is operable to identify a transistor in the logic gate having an output to either a ground or a voltage source as the at least one transistor.

In one or more embodiments the processing circuitry is operable to measure a voltage output swing at each of the plurality of transistors in the logic function to identify the at least one transistor having a voltage swing above the predetermined threshold, and identify a transistor with a highest voltage output swing as the at least one transistor.

In one or more embodiments the processing circuitry operable to identify the least one transistor in the plurality of transistors having the voltage swing to an output above the predetermined threshold is further operable to determine a guard-band associated with each of the plurality of transistors to add to a nominal voltage that avoids timing constraints on the logic gate and couple the voltage dividing transistor when the voltage dividing transistor is within the guard-band.

In one or more embodiments, the logic function for the logic gate is an OR/AND/INVERTER (OAI) or an AND/OR/INVERTER (AOI) logic function.

Another embodiment is directed to a standard cell including a plurality of CMOS transistors organized to provide a logic function for a logic gate, at least one transistor within the plurality of transistors having a voltage swing to an output above a predetermined threshold, and a voltage dividing transistor coupled to the at least one transistor, the voltage dividing transistor operable to reduce a voltage across the at least one transistor such that the voltage dividing transistor lowers a voltage across the at least one transistor thereby reducing aging of the logic gate.

In one or more embodiments, a measured voltage output swing between each of the plurality of transistors in the logic gate identifies a transistor with a highest voltage output swing as the at least one transistor.

In one or more embodiments each of the plurality of transistors forming the standard cell has a nominal voltage and a guard-band associated with each of the plurality of transistors to define timing constraints on the logic gate and the voltage dividing transistor is within the guard-band.

In one or more embodiments the voltage dividing transistor coupled to the at least one transistor is stacked across a transistor drain and source (Vds).

In one or more embodiments, the least one transistor in the plurality of transistors is a singleton transistor subject to hot carrier effects.

In one or more embodiments, the logic function for the logic gate is an OR/AND/INVERTER (OAI) or an AND/OR/INVERTER (AOI) logic function.

A standard cell (SC) is a key piece of digital design from Internet of Things (IoT) applications as well as processing applications. The performance of a SC determines the overall system performance. Most of SC variants are designed to maximize Power, Performance, and Area (PPA). For mission critical systems such as Functional Safety (FuSA), automotive, high-performance computing, optimizing the design for reliability becomes as necessary as PPA. However, most SCs are not designed for the reliability optimization. Thus, methods and system herein provide a design topology for SC reliability and hardening. Methods and logic gate designs herein are directed to mitigation of the aging impact on SC synthesis.

In one or more embodiments, a method for a design topology is based on the estimations from silicon simulations to account for necessary voltage guard-bands from pre-silicon simulation and/or silicon measurement, aging guard-band added to the nominal Vcc not to avoid timing constraints which can result in leaving unnecessary performance margin on the table.

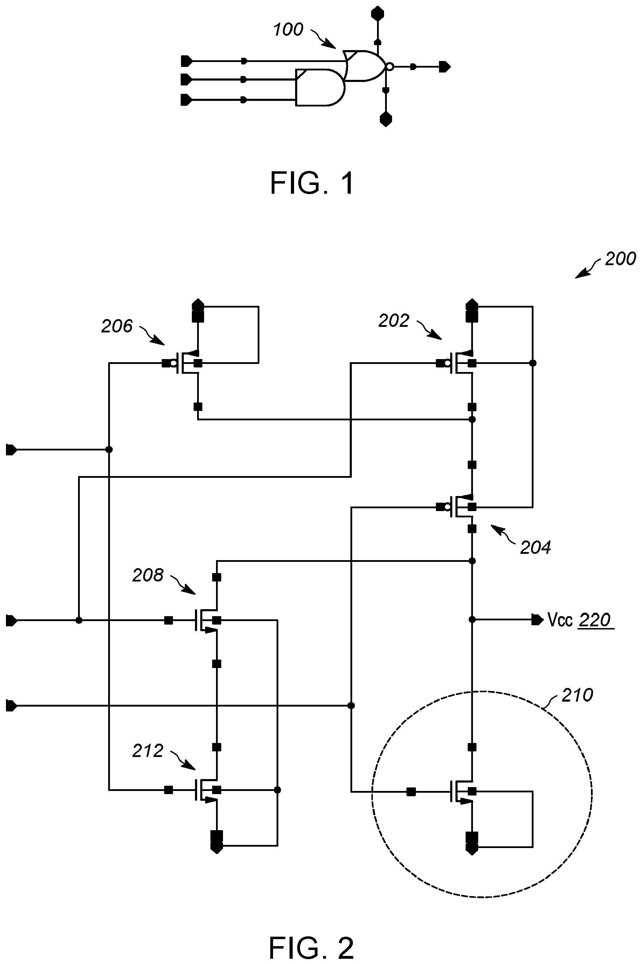

Referring now to FIG. 1, in accordance with one or more embodiments, an AOI logic gate 100 is shown (e.g., AND-OR-invert). Typical AOI logic gates are CMOS transistors with voltage requirements Transistor properties include the property that operating voltage may be between 1.2 - 1.3 volts in an AOI cell.

Referring now to FIG. 2, a CMOS transistor implementation 200 of the AOI logic gate 100 of FIG. 1 is shown. As shown, the CMOS transistor implementation 200 includes six transistors (transistor 202, transistor 204, transistor 206, transistor 208, transistor 210, and transistor 212). Transistor 210 illustrates a singleton transistor subjected to higher voltage degradation due to its location between voltage rails. During operating conditions, transistor 210 ages faster than other transistors shown in FIG. 2 due to the proximity of the transistor to Vcc 220. For example, transistor 202 and transistor 204 are coupled in series, and unlike transistor 210, neither transistor 202 nor transistor 204 is directly coupled to Vcc 220, and therefore will not be subject to the same voltages as transistor 210 (e.g., transistor 202 and transistor 204 may be subject to about half the voltage received at transistor 210).

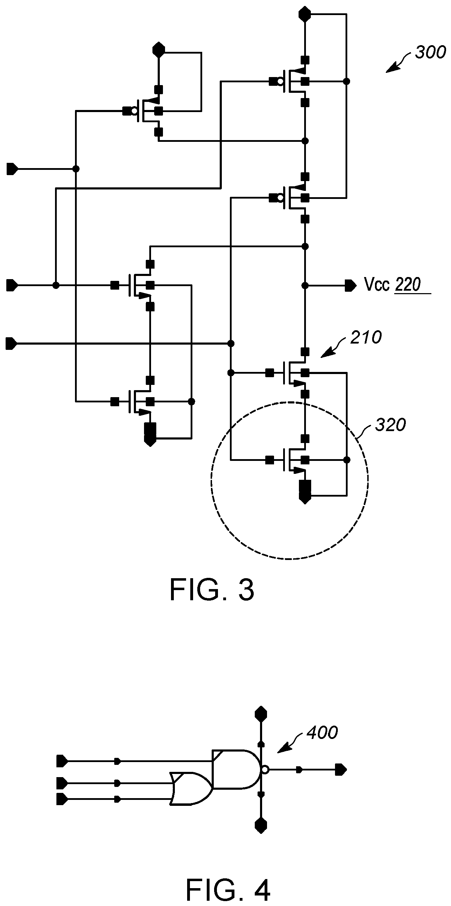

Referring now to FIG. 3, a CMOS transistor implementation 300 is illustrated in accordance with an embodiment that includes an added stacked transistor 320 to the CMOS transistor implementation 200 of FIG. 2. As shown in the CMOS transistor implementation 300, transistor 210 no longer experiences a full swing from rail to rail to Vcc 220. The added stacked transistor 320 is included by coupling the respective gates such that functionality of the AOI transistor circuit does not change.

Referring to Table 1 below, a representative example of a standard cell AOI illustrates typical degradation of the different CMOS transistors, such as the six transistors shown in FIG. 2, including three PMOS and three NMOS transistors, showing that each transistor may degrade differently over time as a function of the location of the transistor in the logic gate.

**Table. 1: Standard cell aging degradation after 5 years of operation**

| Transistor | Percent Degradation |
|---|---|
| NMOS | 16.4054 |
| NMOS | 13.4704 |
| NMOS | 13.2244 |
| PMOS | 24.9525 |
| PMOS | 25.0775 |
| PMOS | 25.0775 |

**Table. 2: AOI aging degradation after 5 years of operation with added NMOS voltage dividing transistor**

| Transistor | Percent Degradation |
|---|---|
| NMOS | 9.93469 |
| NMOS | 9.93605 |
| NMOS | 9.01996 |
| NMOS | 9.02001 |
| PMOS | 19.8275 |
| PMOS | 19.6094 |
| PMOS | 19.6094 |

As shown in Table 2, stacking an additional NMOS transistor in series like the stacked transistor 320 as shown in FIG. 3 may result in an aging-tolerant SC. Further, a comparison in the NMOS transistors before and after adding the stacked transistor 320 shows a 26.3% improvement in NMOS drain current degradation and 26.49% improvement in PMOS drain current degradation.

Referring now to FIG. 4, a OAI logic circuit 400 is illustrated showing the basic construction for combining the logic circuits of FIG. 1 between input and output.

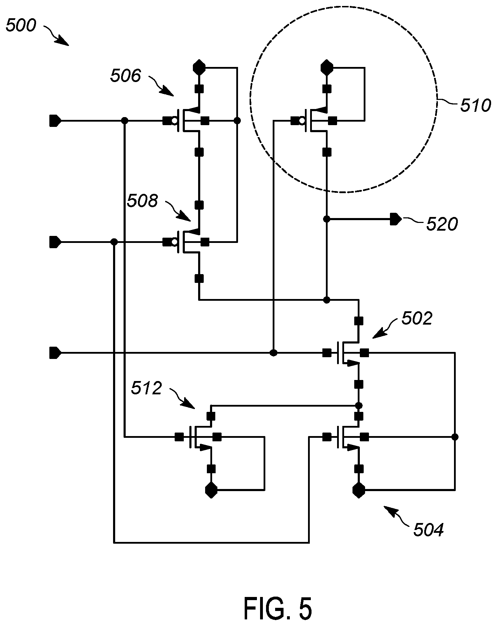

Referring now to FIG. 5, a CMOS transistor implementation 500 of the OAI logic circuit 400 of FIG. 4 is shown. As shown in FIG. 5, the CMOS transistor implementation 500 includes six transistors (e.g., transistor 502, transistor 504, transistor 506, transistor 508, transistor 510, transistor 512). Transistor 510 illustrates a singleton transistor subjected to higher voltage degradation due to its location between voltage rails. During operating conditions, transistor 510 ages faster than the other transistors shown in FIG. 5 due to the proximity of the transistor 510 to Ground 520. For example, transistor 502 and 504 are coupled in series, and unlike transistor 510, neither transistor 502 nor transistor 504 is directly coupled to Ground 520, and therefore is not subject to the same voltages as transistor 510 (e.g., transistor 502 and transistor 504 may be subject to about half the voltage received at transistor 510).

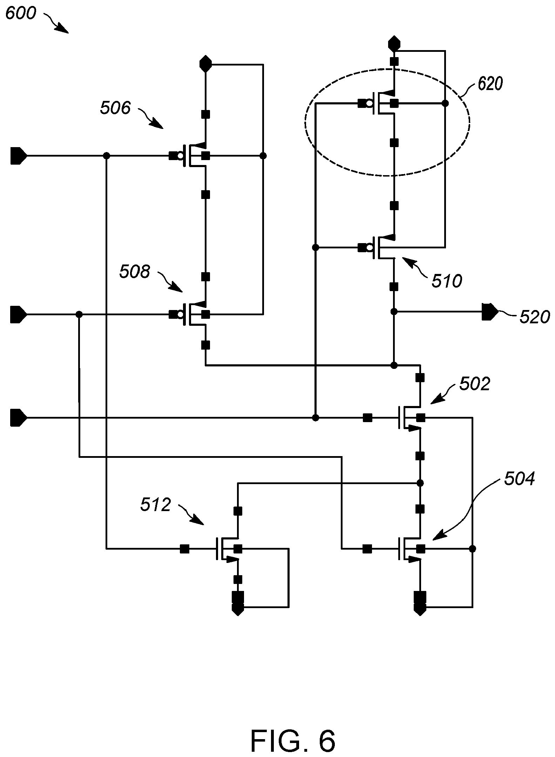

Referring now to FIG. 6, a CMOS transistor implementation 600 is illustrated in accordance with an embodiment that includes an added stacked transistor 620. As shown, transistor 510 of FIG. 5 now no longer experiences a full swing from rail to rail to Ground 520. The added transistor 620 is included by coupling the respective gates such that functionality of the OAI transistor circuit does not change.

**Table. 3: Standard cell OAI aging degradation after five years of operation**

| Transistor | Percent Degradation |
|---|---|
| NMOS | 13.3463 |
| NMOS | 13.3463 |
| NMOS | 14.8151 |
| PMOS | 24.7432 |
| PMOS | 24.4462 |
| PMOS | 24.8095 |

**Table. 4: Standard cell with added PMOS voltage dividing transistor OAI aging degradation after five years of operation**

| Transistor | Percent Degradation |
|---|---|
| NMOS | 9.08598 |
| NMOS | 9.08598 |
| NMOS | 11.4557 |
| PMOS | 19.4765 |
| PMOS | 19.4766 |
| PMOS | 19.4937 |
| PMOS | 19.4938 |

As shown in Table 4, stacking the additional PMOS transistor 620 in series as shown in FIG. 6 results in an aging tolerant SC. Further, a comparison in the MOS transistors before and after adding transistor 620 shows improvements in NMOS drain current degradation and improvements in PMOS drain current degradation similar to the improvements shown for the AOI SC shown in Tables 1 and 2 above.

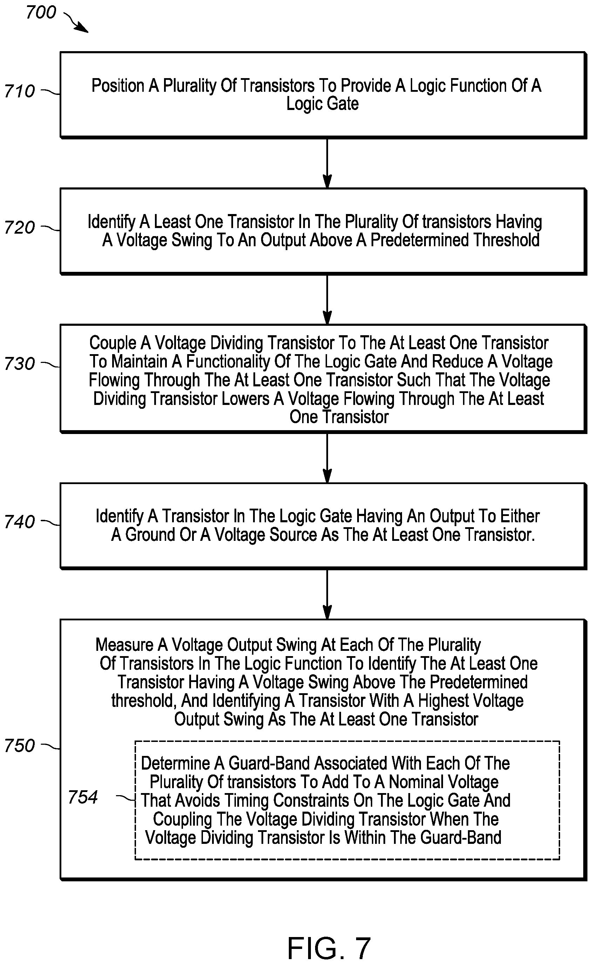

Referring now to FIG. 7, a flow diagram 700 illustrates a method in accordance with one or more embodiments.

Block 710 provides for positioning a plurality of transistors organized to provide a logic function of a logic gate. For example, as shown in FIGs. 2 and 5, logic cells of the CMOS transistor implementation 200 and of the CMOS transistor implementation 500 illustrate AOI and OAI logic gates.

Block 720 provides for identifying a least one transistor in the plurality of transistors having a voltage swing to an output above a predetermined threshold. For example, as shown in FIGs. 2 and 5, transistors 210 and 510 identify transistors having a voltage swing above a predetermined threshold.

Block 730 provides for coupling a voltage dividing transistor to the at least one transistor to reduce a voltage across the at least one transistor such that the voltage dividing transistor lowers a voltage across the at least one transistor. For example, as shown in FIGs. 3 and 6, transistors 320 and 620 are voltage dividing transistors that do not undermine the function of the logic gate as shown in FIGs. 1 and 4 while not undermining the functionality of the respective logic gate.

Block 740 provides for identifying a transistor in the logic gate having an output to either a ground or a voltage source as the at least one transistor. For example, in FIG. 2, transistor 210 has an output to Vcc 220, and in FIG. 5, transistor 510 has an output coupled to ground 520.

Block 750 provides for measuring a voltage output swing at each of the plurality of transistors in the logic function to identify the at least one transistor having a voltage swing above the predetermined threshold, and identifying a transistor with a highest voltage output swing as the at least one transistor. For example, each of transistors shown in FIG. 2 and 5 may be measured to determine a voltage swing across each transistor to identify a transistor most affected by heat carrier effects and the like.

Block 754 shown within block 750 provides for optionally determining a guard-band associated with each of the plurality of transistors to add to a nominal voltage that avoids timing constraints on the logic gate and coupling the voltage dividing transistor when the voltage dividing transistor is within the guard-band.

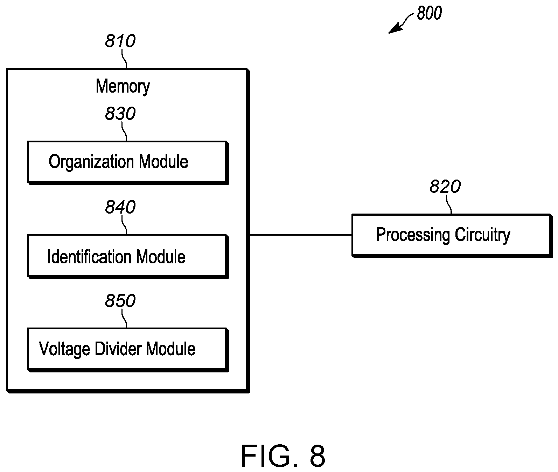

Referring now to FIG. 8, one embodiment is directed to a system 800 for forming a logic gate, such as a standard cell with reduced aging. As shown, system 800 includes memory 810 coupled to processing circuitry 820. Memory 810 includes a plurality of modules to form a logic gate by determining whether alterations in the standard cell may reduce aging. More particularly, memory 810 includes organization module 830 to organize a plurality of transistors to form a logic function such as an AOI or OAI type function, identification module 840 to identify a least one transistor in the plurality of transistors having a voltage swing to an output above a predetermined threshold, and voltage divider module 850 to determine where within the standard cell to couple at least one transistor operable to reduce a voltage across the at least one transistor based on the criteria identified in identification module 840 such that the voltage dividing transistor lowers a voltage across the at least one transistor thereby reducing aging of the logic gate.

In one or more embodiments, module 840 is configured to identify a transistor in the logic gate having an output to either a ground or a voltage source as the at least one transistor.

In one or more embodiments, identification module 840 is further configured to measure a voltage output swing between each of the plurality of transistors in the logic gate to identify the at least one transistor having a voltage swing above the predetermined threshold such that identification module 840 may identify a transistor with a highest voltage output swing as the at least one transistor.

In one or more embodiments, identification module 840 is further configured to determine a guard-band associated with each of the plurality of transistors to add to a nominal voltage that avoids timing constraints on the logic gate, and direct that the voltage dividing transistor be coupled when the voltage dividing transistor is within the guard-band. The voltage dividing transistor to be stacked across a transistor drain and source (Vds).

In one embodiment, the identification module 840 is configured to identify a singleton transistor as the at least one transistor within the logic gate subject to hot carrier effects.

In the above disclosure, reference has been made to the accompanying drawings, which form a part hereof, which illustrate specific implementations in which the present disclosure may be practiced. It is understood that other implementations may be utilized, and structural changes may be made without departing from the scope of the present disclosure. References in the specification to "one embodiment," "an embodiment," "an example embodiment," "an example embodiment," "example implementation," etc., indicate that the embodiment or implementation described may include a particular feature, structure, or characteristic, but every embodiment or implementation may not necessarily include the particular feature, structure, or characteristic. Moreover, such phrases are not necessarily referring to the same embodiment or implementation. Further, when a particular feature, structure, or characteristic is described in connection with an embodiment or implementation, one skilled in the art will recognize such feature, structure, or characteristic in connection with other embodiments or implementations whether or not explicitly described. For example, various features, aspects, and actions described above with respect to an autonomous parking maneuver are applicable to various other autonomous maneuvers and must be interpreted accordingly.

Implementations of the systems, apparatuses, devices, and methods disclosed herein may comprise or utilize one or more devices that include hardware, such as, for example, one or more processors and system memory, as discussed herein. An implementation of the devices, systems, and methods disclosed herein may communicate over a computer network. A "network" is defined as one or more data links that enable the transport of electronic data between computer systems and/or modules and/or other electronic devices. When information is transferred or provided over a network or another communications connection (either hardwired, wireless, or any combination of hardwired or wireless) to a computer, the computer properly views the connection as a transmission medium. Transmission media can include a network and/or data links, which can be used to carry desired program code means in the form of computer-executable instructions or data structures and which can be accessed by a general purpose or special purpose computer. Combinations of the above should also be included within the scope of non-transitory computer-readable media.

A memory device can include any one memory element or a combination of volatile memory elements (e.g., random access memory (RAM, such as DRAM, SRAM, SDRAM, etc.)) and non-volatile memory elements (e.g., ROM, hard drive, tape, CDROM, etc.). Moreover, the memory device may incorporate electronic, magnetic, optical, and/or other types of storage media. In the context of this document, a "non-transitory computer-readable medium" can be, for example but not limited to, an electronic, magnetic, optical, electromagnetic, infrared, or semiconductor system, apparatus, or device. More specific examples (a non-exhaustive list) of the computer-readable medium would include the following: a portable computer diskette (magnetic), a random-access memory (RAM) (electronic), a read-only memory (ROM) (electronic), an erasable programmable read-only memory (EPROM, EEPROM, or Flash memory) (electronic), and a portable compact disc read-only memory (CD ROM) (optical). Note that the computer-readable medium could even be paper or another suitable medium upon which the program is printed, since the program can be electronically captured, for instance, via optical scanning of the paper or other medium, then compiled, interpreted or otherwise processed in a suitable manner if necessary, and then stored in a computer memory.

Those skilled in the art will appreciate that the present disclosure may be practiced in network computing environments with many types of computer system configurations, including indash vehicle computers, personal computers, desktop computers, laptop computers, message processors, nomadic devices, multi-processor systems, microprocessor-based or programmable consumer electronics, network PCs, minicomputers, mainframe computers, mobile telephones, PDAs, tablets, pagers, routers, switches, various storage devices, and the like. The disclosure may also be practiced in distributed system environments where local and remote computer systems, which are linked (either by hardwired data links, wireless data links, or by any combination of hardwired and wireless data links) through a network, both perform tasks. In a distributed system environment, program modules may be located in both the local and remote memory storage devices.

Further, where appropriate, the functions described herein can be performed in one or more of hardware, software, firmware, digital components, or analog components. For example, one or more application specific integrated circuits (ASICs) can be programmed to carry out one or more of the systems and procedures described herein. Certain terms are used throughout the description, and claims referto particular system components. As one skilled in the art will appreciate, components may be referred to by different names. This document does not intend to distinguish between components that differ in name, but not function.

At least some embodiments of the present disclosure have been directed to computer program products comprising such logic (e.g., in the form of software) stored on any computer-usable medium. Such software, when executed in one or more data processing devices, causes a device to operate as described herein.

Example 1 may include a method for forming a logic gate with reduced aging, the method comprising: positioning a plurality of transistors to provide a logic function for the logic gate; and coupling a voltage dividing transistor to at least one transistor of a plurality of transistors, the voltage dividing transistor operable to: reduce a voltage across the at least one transistor such that the voltage dividing transistor lowers a voltage across the at least one transistor.

Example 2 may include the method of example 1 and/or any other example herein, further comprising: identifying a transistor in the logic gate having an output to either a ground or a voltage source as the at least one transistor.

Example 3 may include the method of example 1 and/or any other example herein, further comprising: measuring a voltage output swing at each of the plurality of transistors in the logic function to identify the at least one transistor having a voltage swing above the predetermined threshold; and identifying a transistor with a highest voltage output swing as the at least one transistor.

Example 4 may include the method of example 1 and/or any other example herein, wherein the identifying the least one transistor in the plurality of transistors having the voltage swing to an output above the predetermined threshold further comprises: determining a guard-band associated with each of the plurality of transistors to add to a nominal voltage that avoids timing constraints on the logic gate; and coupling the voltage dividing transistor when the voltage dividing transistor is within the guard-band.

Example 5 may include the method of example 1 and/or any other example herein, wherein the coupling the voltage dividing transistor to the at least one transistor further comprises: coupling the voltage dividing transistor across a transistor drain and source (Vds) by stacking the transistor.

Example 6 may include the method of example 1 and/or any other example herein, wherein the identifying a least one transistor in the plurality of transistors having the voltage swing to the output above the predetermined threshold further comprises: identifying a singleton transistor subject to hot carrier effects as the at least one transistor.

Example 7 may include at least one non-transitory computer readable medium comprising computer readable instructions to cause processor circuitry to at least: position a plurality of transistors to provide a logic function for a logic gate; and insert a voltage dividing transistor coupled to at least one transistor of the plurality of transistors, the voltage dividing transistor operable to reduce a voltage across the at least one transistor.

Example 8 may include the at least one non-transitory computer readable medium of example 7 and/or any other example herein, wherein the transistor in the logic gate comprises an output to either a ground or a voltage source.

Example 9 may include the at least one non-transitory computer readable medium of example 7 and/or any other example herein, wherein a voltage output swing at each of the plurality of transistors in the logic function is associated with identifying a transistor, of plurality of transistors, having a voltage swing above the predetermined threshold is the transistor.

Example 10 may include the at least one non-transitory computer readable medium of example 7 and/or any other example herein, wherein a guard-band associated with each of the plurality of transistors is configured to add to a nominal voltage that avoids timing constraints on the logic gate, and wherein the voltage dividing transistor is coupled when the voltage dividing transistor is within the guard-band.

Example 11 may include the at least one non-transitory computer readable medium of example 7 and/or any other example herein, wherein the voltage dividing transistor is coupled across a transistor drain and source (Vds) by stacking the transistor.

Example 12 may include the at least one non-transitory computer readable medium of example 7 and/or any other example herein, wherein a singleton transistor is transistor within the logic gate and is subject to hot carrier effects.

Example 13 may include the at least one non-transitory computer readable medium of example 7 and/or any other example herein, wherein the logic function for the logic gate is an OR/AND/INVERTER (OAI) or a AND/OR/INVERTER (AOI) logic function.

Example 14 may include a standard cell comprising: a plurality of CMOS transistors organized to provide a logic function for a logic gate; and a voltage dividing transistor coupled to at least one transistor of a plurality of transitors, the voltage dividing transistor operable to: reduce a voltage across the at least one transistor such that the voltage dividing transistor lowers a voltage across the at least one transistor thereby reducing aging of the logic gate.

Example 15 may include the standard cell of example 14 and/or any other example herein wherein the at least one transistor has an output to either a ground or a voltage source.

Example 16 may include the standard cell of example 14 and/or any other example herein wherein a measured voltage output swing between each of the plurality of transistors in the logic gate identifies a transistor with a highest voltage output swing as the at least one transistor.

Example 17 may include the standard cell of example 14 and/or any other example herein wherein each of the plurality of transistors forming the standard cell has a nominal voltage and a guard-band associated with each of the plurality of transistors to define timing constraints on the logic gate and the voltage dividing transistor is within the guard-band.

Example 18 may include the standard cell of example 14 and/or any other example herein wherein the voltage dividing transistor coupled to the at least one transistor is stacked across a transistor drain and source (Vds).

The standard cell of example 14 and/or any other example herein wherein the least one transistor in the plurality of transistors is a singleton transistor subject to hot carrier effects.

The standard cell of example 14 and/or any other example herein wherein the logic function for the logic gate is an OR/AND/INVERTER (OAI) or a AND/OR/INVERTER (AOI) logic function.

While various embodiments of the present disclosure have been described above, it should be understood that they have been presented by way of example only, and not limitation. It will be apparent to persons skilled in the relevant art that various changes in form and detail can be made therein without departing from the scope of the present disclosure. Thus, the breadth and scope of the present disclosure should not be limited by any of the above-described example embodiments but should be defined only in accordance with the following claims and their equivalents. The foregoing description has been presented for the purposes of illustration and description. It is not intended to be exhaustive or to limit the present disclosure to the precise form disclosed. Many modifications and variations are possible in light of the above teaching. Further, it should be noted that any or all of the aforementioned alternate implementations may be used in any combination desired to form additional hybrid implementations of the present disclosure. For example, any of the functionality described with respect to a particular device or component may be performed by another device or component. Further, while specific device characteristics have been described, embodiments of the disclosure may relate to numerous other device characteristics. Further, although embodiments have been described in language specific to structural features and/or methodological acts, it is to be understood that the disclosure is not necessarily limited to the specific features or acts described. Rather, the specific features and acts are disclosed as illustrative forms of implementing the embodiments. Conditional language, such as, among others, "can," "could," "might," or "may," unless specifically stated otherwise, or otherwise understood within the context as used, is generally intended to convey that certain embodiments could include, while other embodiments may not include, certain features, elements, and/or steps. Thus, such conditional language is not generally intended to imply that features, elements, and/or steps are in any way required for one or more embodiments.

### TERMINOLOGY

For the purposes of the present document, the following terms and definitions are applicable to the examples and embodiments discussed herein.

The term "circuitry" as used herein refers to, is part of, or includes hardware components such as an electronic circuit, a logic circuit, a processor (shared, dedicated, or group) and/or memory (shared, dedicated, or group), an Application Specific Integrated Circuit (ASIC), a field-programmable device (FPD) (e.g., a field-programmable gate array (FPGA), a programmable logic device (PLD), a complex PLD (CPLD), a high-capacity PLD (HCPLD), a structured ASIC, or a programmable SoC), digital signal processors (DSPs), etc., that are configured to provide the described functionality. In some embodiments, the circuitry may execute one or more software or firmware programs to provide at least some of the described functionality. The term "circuitry" may also refer to a combination of one or more hardware elements (or a combination of circuits used in an electrical or electronic system) with the program code used to carry out the functionality of that program code. In these embodiments, the combination of hardware elements and program code may be referred to as a particular type of circuitry.

The term "processor circuitry" as used herein refers to, is part of, or includes circuitry capable of sequentially and automatically carrying out a sequence of arithmetic or logical operations, or recording, storing, and/or transferring digital data. Processing circuitry may include one or more processing cores to execute instructions and one or more memory structures to store program and data information. The term "processor circuitry" may refer to one or more application processors, one or more baseband processors, a physical central processing unit (CPU), a single-core processor, a dual-core processor, a triple-core processor, a quad-core processor, and/or any other device capable of executing or otherwise operating computer-executable instructions, such as program code, software modules, and/or functional processes. Processing circuitry may include more hardware accelerators, which may be microprocessors, programmable processing devices, or the like. The one or more hardware accelerators may include, for example, computer vision (CV) and/or deep learning (DL) accelerators. The terms "application circuitry" and/or "baseband circuitry" may be considered synonymous to, and may be referred to as, "processor circuitry."

The term "interface circuitry" as used herein refers to, is part of, or includes circuitry that enables the exchange of information between two or more components or devices. The term "interface circuitry" may refer to one or more hardware interfaces, for example, buses, I/O interfaces, peripheral component interfaces, network interface cards, and/or the like.

The term "computer system" as used herein refers to any type interconnected electronic devices, computer devices, or components thereof. Additionally, the term "computer system" and/or "system" may refer to various components of a computer that are communicatively coupled with one another. Furthermore, the term "computer system" and/or "system" may refer to multiple computer devices and/or multiple computing systems that are communicatively coupled with one another and configured to share computing and/or networking resources.

The terms "coupled," "communicatively coupled," along with derivatives thereof are used herein. The term "coupled" may mean two or more elements are in direct physical or electrical contact with one another, may mean that two or more elements indirectly contact each other but still cooperate or interact with each other, and/or may mean that one or more other elements are coupled or connected between the elements that are said to be coupled with each other. The term "directly coupled" may mean that two or more elements are in direct contact with one another. The term "communicatively coupled" may mean that two or more elements may be in contact with one another by a means of communication including through a wire or other interconnect connection, through a wireless communication channel or link, and/or the like.

## Claims

1. A method for forming a logic gate with reduced aging, the method comprising:
positioning a plurality of transistors to provide a logic function for the logic gate; and
coupling a voltage dividing transistor to at least one transistor in the plurality of transistors, the voltage dividing transistor operable to:
reduce a voltage across the at least one transistor such that the voltage dividing transistor lowers a voltage across the at least one transistor.

2. The method of claim 1, further comprising:
identifying a transistor in the logic gate having an output to either a ground or a voltage source as the at least one transistor.

3. The method of claim 1, further comprising:
measuring a voltage output swing at each of the plurality of transistors in the logic function to identify the at least one transistor having a voltage swing above a predetermined threshold; and
identifying a transistor with a highest voltage output swing as the at least one transistor.

4. The method of claim 1, further comprising:
determining a guard-band associated with each of the plurality of transistors to add to a nominal voltage that avoids timing constraints on the logic gate; and
coupling the voltage dividing transistor when the voltage dividing transistor is within the guard-band.

5. The method of claim 1, wherein the coupling the voltage dividing transistor to the at least one transistor further comprises:
coupling the voltage dividing transistor across a transistor drain and source (Vds) by stacking the transistor.

6. The method of any one of claims 1-5, further comprising:
identifying a singleton transistor subject to hot carrier effects as the at least one transistor.

7. A computer readable medium comprising computer readable instructions to cause processor circuitry to at least:
position a plurality of transistors to provide a logic function for a logic gate; and
insert a voltage dividing transistor coupled to at least one transistor of the plurality of transistors, the voltage dividing transistor operable to reduce a voltage across the at least one transistor.

8. The computer readable medium of claim 7, wherein the transistor in the logic gate comprises an output to either a ground or a voltage source.

9. The computer readable medium of claim 7, wherein a voltage output swing at each of the plurality of transistors in the logic function is associated with identifying a transistor, of the plurality of transistors, having a voltage swing above a predetermined threshold is the transistor.

10. The computer readable medium of claim 7, wherein a guard-band associated with each of the plurality of transistors is configured to add to a nominal voltage that avoids timing constraints on the logic gate, and wherein the voltage dividing transistor is coupled when the voltage dividing transistor is within the guard-band.

11. The computer readable medium of claim 7, wherein the voltage dividing transistor is coupled across a transistor drain and source (Vds) by stacking the transistor.

12. The computer readable medium of any one of claims 7-11, wherein a singleton transistor is transistor within the logic gate and is subject to hot carrier effects.

13. A standard cell comprising:
a plurality of CMOS transistors organized to provide a logic function for a logic gate; and
a voltage dividing transistor coupled to at least one transistor of a plurality of transitors, the voltage dividing transistor operable to:
reduce a voltage across the at least one transistor such that the voltage dividing transistor lowers a voltage across the at least one transistor thereby reducing aging of the logic gate.

14. The standard cell of claim 13, wherein the at least one transistor has an output to either a ground or a voltage source.

15. The standard cell of any one of claims 13-14, wherein a measured voltage output swing between each of the plurality of transistors in the logic gate identifies a transistor with a highest voltage output swing as the at least one transistor.
